# EUROPÄISCHE PATENTSCHRIFT

(11) **EP 3 518 059 B1**
(45) Veröffentlichungstag und Bekanntmachung des Hinweises auf die Patenterteilung: **01.04.2020**
(21) Anmeldenummer: 18153148.4
(22) Anmeldetag: 24.01.2018
(51) Int. Cl.: G05B 19/4061, B25J 9/16, G05B 19/4069

(54) **VERFAHREN ZUR RECHNERGESTÜTZTEN BENUTZERASSISTENZ BEI DER IN-BETRIEBNAHME EINES BEWEGUNGSPLANERS FÜR EINE MASCHINE**
METHOD FOR COMPUTER-ASSISTED USER ASSISTANCE IN THE OPERATION OF A MOVEMENT PLANER FOR A MACHINE
PROCÉDÉ D'AIDE À L'UTILISATEUR ASSISTÉE PAR ORDINATEUR LORS DE LA MISE EN SERVICE D'UN PLANIFICATEUR DE DÉPLACEMENT POUR UNE MACHINE

(43) Veröffentlichungstag der Anmeldung: 31.07.2019
(73) Patentinhaber: Siemens Aktiengesellschaft, 80333 München (DE)
(72) Erfinder: Neubauer, Werner, 81739 München (DE); Schmitt, Philipp Sebastian, 81735 München (DE)

(56) Entgegenhaltungen:
- EP-A1- 2 853 354
- DE-A1-102015 204 641
- US-A1- 2015 328 776
- BURGER RUBEN ET AL: "Automated tuning and configuration of path planning algorithms", 2017 IEEE INTERNATIONAL CONFERENCE ON ROBOTICS AND AUTOMATION (ICRA), IEEE, 29. Mai 2017 (2017-05-29), Seiten 4371-4376, XP033127293, DOI: 10.1109/ICRA.2017.7989504 [gefunden am 2017-07-21]

## Beschreibung

Die Erfindung betrifft ein Verfahren zur rechnergestützten Benutzerassistenz bei der Inbetriebnahme eines Bewegungsplaners für eine Maschine. Darüber hinaus betrifft die Erfindung ein Computerprogrammprodukt und ein Computerprogramm.

In vielen technischen Gebieten werden Maschinen automatisiert zur Durchführung bestimmter Aufgaben bewegt. Beispiele von solchen Maschinen sind Industrieroboter, medizinische Geräte oder Werkzeugmaschinen. Üblicherweise kommen bei der automatisierten Bewegung von Maschinen Bewegungsplaner zum Einsatz, bei denen es sich um Programme handelt, die geeignete Bewegungstrajektorien der Maschine ermitteln, so dass keine Kollision zwischen Bauteilen der Maschine oder der Umgebung auftreten.

Bewegungsplaner sind in der Regel generische Programme, welche für unterschiedliche Maschinentypen und räumliche Umgebungen verwendet werden können. Um den Bewegungsplaner an die aktuellen Gegebenheiten anzupassen, werden bei dessen Inbetriebnahme Parametrierungsdaten durch einen Benutzer über eine Benutzerschnittstelle spezifiziert. Diese Parametrierungsdaten umfassen ein Maschinenmodell und ein Umgebungsmodell. Das Maschinenmodell beschreibt unter anderem die geometrischen Abmessungen der Maschine, wohingegen das Umgebungsmodell die geometrischen Abmessungen der Umgebung enthält, in der die Maschine betrieben werden soll.

Nach Parametrierung eines Bewegungsplaners werden bei dessen Verwendung zur Steuerung der entsprechenden Maschine kollisionsfreie Bewegungstrajektorien (sofern vorhanden) berechnet, welche jeweils zwischen einer von einem Benutzer spezifizierten Start- und Ziel-Konfiguration im Konfigurationsraum der Maschine verlaufen. Die Maschine wird gemäß der jeweiligen Trajektorie gesteuert, so dass sie sich entlang dieser Trajektorie im Raum bewegt.

Nach Abschluss der Parametrierung eines Bewegungsplaners wird oftmals festgestellt, dass Planungsanfragen für eine Vielzahl von Start- und Ziel-Konfigurationen sehr lange Rechenzeiten zur Ermittlung einer kollisionsfreien Trajektorie benötigen bzw. gar keine kollisionsfreie Trajektorie gefunden werden kann. Die Suche nach den Ursachen für langsame oder scheiternde Planungsanfragen ist schwierig und erfordert heutzutage Expertenwissen. Es ist deshalb wünschenswert, schon bei der Inbetriebnahme des Bewegungsplaners im Rahmen seiner Parametrierung zu erkennen, ob die Parametrierungsdaten fehler- oder problembehaftet sind, so dass Probleme bei der späteren Verwendung des Bewegungsplaners vermieden werden.

Das Dokument DE 10 2015 204 641 A1 beschreibt ein Verfahren zur Programmierung eines Roboters, bei dem Ausführungsmodule, die Bestandteil einer vordefinierten Bewegungsschablone einer auszuführenden Roboterbewegung sind, mit Hilfe eines Lernmoduls in einem Initialisierungsprozess parametriert werden. Im Rahmen des Initialisierungsprozesses werden ein oder mehrere Konfigurationen des Roboters aufgezeichnet und das Lernmodul ermittelt basierend auf den aufgezeichneten Konfigurationen Parameter für die Ausführungsmodule.

Die Druckschrift EP 2 853 354 A1 offenbart eine Steuereinrichtung einer Maschine mit mehreren lagegeregelten Achsen, wobei die Steuereinrichtung unter Abarbeitung eines Systemprogramms die lagegeregelten Achsen gemäß eines Teileprogramms ansteuert. Im Rahmen der Ansteuerung wird ein Endeffektor entlang einer definierten Bahn bewegt. Vor dem Ansteuern der lagegeregelten Achsen prüft die Steuereinrichtung unter Abarbeitung des Systemprogramms mittels eines parametrierbaren Modells der Maschine, ob das Verfahren des Endeffektors entlang der definierten Bahn kollisionsfrei möglich ist. Ist dies nicht der Fall, wird eine entsprechende Fehlermeldung an den Bediener ausgegeben.

Aufgabe der Erfindung ist es, ein Verfahren zur rechnergestützten Benutzerassistenz bei der Inbetriebnahme eines Bewegungsplaners für eine Maschine zu schaffen, mit dem einem Benutzer Informationen über mögliche Fehler oder Probleme in den Parametrierungsdaten des Bewegungsplaners gegeben werden.

Diese Aufgabe wird durch das Verfahren gemäß Patentanspruch 1 bzw. die Vorrichtung gemäß Patentanspruch 10 bzw. das Computerprogrammprodukt gemäß Patentanspruch 13 bzw. durch das Computerprogramm gemäß Patentanspruch 14 gelöst. Weiterbildungen der Erfindung sind in den abhängigen Ansprüchen definiert.

Das erfindungsgemäße Verfahren dient zur rechnergestützten Benutzerassistenz bei der Inbetriebnahme eines Bewegungsplaners für eine Maschine. Ein Bewegungsplaner stellt dabei ein Planungsprogramm dar, welches über einen geeigneten Rechner ausgeführt werden kann und dazu dient, eine kollisionsfreie Bewegung der Maschine im Raum zu ermitteln. Der Begriff der Maschine ist dabei weit zu verstehen und es kann sich hierbei um ein beliebiges technisches Gerät bzw. technisches System handeln, das zur Ausführung automatisierter Bewegungen vorgevorgesehen ist. Insbesondere kann die Maschine einen Industrieroboter oder ein medizinisches Gerät, insbesondere ein bildgebendes Gerät, wie z.B. ein Röntgengerät oder einen Magnetresonanztomographen, umfassen. Ebenso kann die Maschine eine Werkzeugmaschine umfassen.

Im Rahmen des erfindungsgemäßen Verfahrens wird eine Benutzerschnittstelle bereitgestellt, über welche ein Benutzer Parametrierungsdaten für den Bewegungsplaner spezifizieren kann. Diese Spezifikation kann in einer Variante durch eine direkte Eingabe der Parametrierungsdaten über die Benutzerschnittstelle, beispielsweise mittels einer Tastatur und/oder einer Computermaus, erfolgen. Ebenso können die Parametrierungsdaten vorab bereits digital auf einem entsprechenden Speicher hinterlegt sein, so dass der Benutzer in diesem Fall die Parametrierungsdaten durch die Angabe der entsprechenden digitalen Daten über die Benutzerschnittstelle spezifiziert.

Die im Rahmen des erfindungsgemäßen Verfahrens verwendete Benutzerschnittstelle kann verschieden ausgestaltet sein und unterschiedliche Eingabe- und Ausgabemittel umfassen. Vorzugsweise verfügt die Benutzerschnittstelle über ein visuelles Anzeigegerät, wie z.B. ein Display, mit dessen Hilfe die Parametrierungsdaten spezifiziert werden und auf dem die weiter unten beschriebene Warnmeldung angezeigt wird.

Die Parametrierungsdaten umfassen ein Maschinenmodell und ein Umgebungsmodell, wobei das Maschinenmodell unter anderem die geometrischen Abmessungen der Maschine enthält. Demgegenüber beschreibt das Umgebungsmodell die geometrischen Abmessungen der Umgebung, in der die Maschine betrieben werden soll.

Im Rahmen des erfindungsgemäßen Verfahrens wird basierend auf über die Benutzerschnittstelle spezifizierten Parametrierungsdaten der kollisionsfreie und der kollisionsbehaftete Bewegungsraum der Maschine im Konfigurationsraum ermittelt, wobei der Konfigurationsraum einen Raum von Positionsvektoren darstellt, welche jeweils eine räumliche Lage der Maschine repräsentieren. Insbesondere enthalten die Einträge dieser Positionsvektoren die möglichen Positionen von jeweiligen Achsen der Maschine. Der Konfigurationsraum ist somit ein mehrdimensionaler Raum entsprechend der Anzahl von Einträgen in den Positionsvektoren. Der Konfigurationsraum ergibt sich durch das Maschinenmodell.

Unter einem kollisionsfreien Bewegungsraum ist der Bereich im Konfigurationsraum zu verstehen, in dem keine Kollisionen zwischen Bestandteilen der Maschine oder mit anderen Objekten auftreten. Im Gegensatz hierzu beschreibt der kollisionsbehaftete Bewegungsraum solche Orte im Konfigurationsraum, bei denen Kollisionen zwischen Teilen der Maschine bzw. mit anderen Objekten vorliegen. Die entsprechende Bestimmung von kollisionsfreien und kollisionsbehafteten Bewegungsräumen ist an sich bekannt und wird deshalb nicht näher beschrieben.

Nach Ermittlung des kollisionsfreien und des kollisionsbehafteten Bewegungsraums werden ein oder mehrere Merkmale in Bezug auf den kollisionsfreien und/oder kollisionsbehafteten Bewegungsraum ermittelt. Anschließend wird für ein jeweiliges Merkmal zumindest eines Teils der Merkmale ein vorgegebenes Plausibilitätskriterium überprüft, wobei im Falle, dass das Plausibilitätskriterium nicht erfüllt ist, über die Benutzerschnittstelle eine Ausgabe in der Form einer Warnmeldung erzeugt wird.

Im erfindungsgemäßen Verfahren umfasst die über die Benutzerschnittstelle ausgegebene Warnmeldung den Hinweis, dass das Maschinenmodell und/oder Umgebungsmodell möglicherweise fehlerbehaftet ist. Die Erfindung wird dabei vorzugsweise mit weiter unten beschriebenen Ausführungsformen kombiniert. Insbesondere wird der Hinweis ausgegeben, dass das Maschinenmodell möglicherweise fehlerbehaftet ist, wenn das Plausibilitätskriterium betreffend das Verhältnis des Volumens des kollisionsfreien Bewegungsraums als ein Merkmal überprüft wird. Demgegenüber wird im Falle, dass das überprüfte Merkmal eine Anzahl an separaten zusammenhängenden kollisionsfreien Gebieten im Konfigurationsraum umfasst, vorzugsweise der Hinweisausgegeben, dass das Umgebungsmodell möglicherweise fehlerbehaftet ist. Der Hinweis kann z.B. darin bestehen, dass Komponenten der Maschine zu grob (d.h. mit nicht ausreichendem Detaillierungsgrad) modelliert oder falsch platziert sein könnten. Ebenso kann der Hinweis darin bestehen, dass möglicherweise Objekte, wie z.B. künstliche Hindernisse, zu groß modelliert sind. In der detaillierten Beschreibung werden nochmals konkrete Ausgestaltungen entsprechender Hinweise genannt.

Der Begriff des Merkmals ist hier und im Folgenden weit zu verstehen. Insbesondere muss ein Merkmal nicht aus einem einzelnen Wert bestehen, sondern es kann auch komplexe Zusammenhänge beschreiben und hierzu auch eine Mehrzahl von Variablenwerten umfassen.

Das erfindungsgemäße Verfahren zeichnet sich dadurch aus, dass bei der Inbetriebnahme eines Bewegungsplaners die Parametrierungsdaten einer Analyse unterzogen werden, um eventuelle Schwachstellen zu erkennen und den Benutzer hierauf hinzuweisen. Es können somit ohne Hinzuziehung eines Planungsexperten Probleme bei der Parametrierung erkannt werden und geeignete Anpassungen vor dem Einsatz des Planers zur Steuerung der tatsächlichen Maschine vorgenommen werden.

Der Erfindung liegt die Erkenntnis zugrunde, dass über Merkmale in Bezug auf den kollisionsfreien bzw. kollisionsbehafteten Bewegungsraum sehr gut erkannt werden kann, ob die spätere Bewegungsplanung mit dem entsprechenden Bewegungsplaner zu Problemen führen kann.

In einer bevorzugten Variante wird das erfindungsgemäße Verfahren in Kombination mit einem Bewegungsplaner verwendet, der mit unterschiedlichen Planungsalgorithmen betreibbar ist, wobei diese Planungsalgorithmen ggf. über die Benutzerschnittstelle spezifiziert werden können. Dabei umfasst die Warnmeldung eine Empfehlung für zumindest einen dieser Planungsalgorithmen, der am besten für die spezifizierten Parametrierungsdaten geeignet ist. Beispiele von entsprechenden Empfehlungen werden in der detaillierten Beschreibung gegeben.

In einer weiteren bevorzugten Variante wird als ein (überprüftes) Merkmal das Verhältnis des Volumens des kollisionsfreien Bewegungsraums zum Volumen des Konfigurationsraums oder des kollisionsbehafteten Bewegungsraums ermittelt, wobei das Plausibilitätskriterium dann erfüllt ist, wenn das Verhältnis eine vorgegebene Schwelle überschreitet. Hierbei macht man sich die Erkenntnis zunutze, dass ein geringes Volumen des kollisionsfreien Bewegungsraums oftmals zum Schei tern der Bewegungsplanung bzw. zu einer langen Rechenzeit führen.

In einer weiteren Ausgestaltung des erfindungsgemäßen Verfahrens wird als ein (überprüftes) Merkmal die Anzahl an separaten zusammenhängenden kollisionsfreien Gebieten und ggf. auch deren Lage und/oder Volumen im Konfigurationsraum ermittelt, wobei das Plausibilitätskriterium dann erfüllt ist, wenn es nur ein zusammenhängendes Gebiet gibt. In einem zusammenhängenden Gebiet kann jedes Paar von zwei Punkten über eine Bewegungstrajektorie erreicht werden, ohne dass das Gebiet verlassen wird. Diese Variante beruht auf der Erkenntnis, dass bei mehreren separaten zusammenhängenden kollisionsfreien Gebieten die Bewegungsplanung oftmals scheitert, da bei ungünstiger Wahl von Start- und Ziel-Konfiguration jede Bewegungstrajektorie immer einen kollisionsbehafteten Bereich zwischen zwei separaten zusammenhängenden kollisionsfreien Gebieten durchlaufen muss.

In einer weiteren Variante des erfindungsgemäßen Verfahrens wird im Rahmen der Ermittlung des kollisionsfreien und kollisionsbehafteten Bewegungsraums der Konfigurationsraum abgetastet und für jeden Abtastwert bestimmt, ob der Abtastwert (d.h. der entsprechende Positionsvektor im Konfigurationsraum) zu Kollisionen führt oder nicht. Es wird somit sampling-basiert das Volumen und die Lage dieser Bewegungsräume ermittelt.

In einer bevorzugten Variante der soeben beschriebenen Ausführungsform wird im Rahmen der Abtastung des Konfigurationsraums als ein (überprüftes) Merkmal die Häufigkeit des Auftretens jeweiliger Maschinenkomponenten im kollisionsbehafteten Konfigurationsraum in Bezug auf die Gesamtanzahl der Abtastwerte bestimmt. Dabei ist das Plausibilitätskriterium dann erfüllt, wenn die Häufigkeit des Auftretens zumindest einer Maschinenkomponente einen vorgegebenen Schwellwert überschreitet, wobei die Warnmeldung für jede Maschinenkomponente, deren Häufigkeit den vorgegebenen Schwellwert überschreitet, den Hinweis enthält, dass diese Maschinenkomponente möglicherweise unzutreffend (z.B. zu groß der zu grob) modelliert ist. Auf diese Weise werden mittels der Warnmeldung detaillierte Informationen zu problembehafteten Maschinenkomponenten ausgegeben.

In einer weiteren Ausgestaltung des erfindungsgemäßen Verfahrens ist über die Benutzerschnittstelle ferner eine Planungsanfrage mit Start- und Ziel-Konfiguration der Maschine im Konfigurationsraum spezifizierbar, wobei basierend auf einem ermittelten Merkmal, welches die Lage und das Volumen von separaten zusammenhängenden kollisionsfreien Gebieten im Konfigurationsraum spezifiziert, bestimmt wird, ob die Planungsanfrage lösbar ist, wobei im Falle, dass die Planungsanfrage nicht lösbar ist, eine Fehlermeldung über die Benutzerschnittstelle ausgegeben wird. Im Besonderen ist die Planungsanfrage dann nicht lösbar, wenn Start- und Ziel-Konfiguration in unterschiedlichen separaten zusammenhängenden kollisionsfreien Gebieten liegen oder wenn Start- und/oder Zielposition außerhalb eines separaten zusammenhängenden kollisionsfreien Gebiets liegen.

In einer weiteren Ausgestaltung der Erfindung, bei der über die Benutzerschnittstelle ebenfalls eine Planungsanfrage mit Start- und Ziel-Konfiguration der Maschine spezifizierbar ist, wird im Rahmen der Verarbeitung einer spezifizierten Planungsanfrage eine Vielzahl von Bewegungstrajektorien zwischen Start- und Ziel-Konfiguration berechnet, bis eine Bewegungstrajektorie im kollisionsfreien Bewegungsraum gefunden ist oder ein Abbruchkriterium erfüllt ist. Dabei wird für die berechneten Bewegungstrajektorien die Häufigkeit des Auftretens jeweiliger Maschinenkomponenten im kollisionsbehafteten Bewegungsraum in Bezug auf die Gesamtanzahl der berechneten Bewegungstrajektorien ermittelt und für Maschinenkomponenten, deren Häufigkeit einen vorgegebenen Grenzwert überschreitet, ein Warnhinweis über die Benutzerschnittstelle ausgegeben. Auf diese Weise erhält der Benutzer einen Hinweis auf Maschinenkomponenten, die möglicherweise zu groß oder zu grob modelliert sind.

Neben dem oben beschriebenen Verfahren betrifft die Erfindung eine Vorrichtung zur rechnergestützten Benutzerassistenz bei der Inbetriebnahme eines Bewegungsplaners für eine Maschine, wobei die Vorrichtung dazu eingerichtet ist, das erfindungsgemäße Verfahren bzw. eine oder mehrere bevorzugte Varianten des erfindungsgemäßen Verfahrens durchzuführen.

Die Erfindung betrifft darüber hinaus eine Maschine, welche über einen Bewegungsplaner steuerbar ist, wobei die Maschine die soeben beschriebene erfindungsgemäße Vorrichtung zur rechnergestützten Benutzerassistenz bei der Inbetriebnahme des Bewegungsplaners umfasst.

Ferner umfasst die Erfindung ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird. Die Erfindung betrifft darüber hinaus ein Computerprogramm mit einem Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Ausführungsbeispiele der Erfindung werden nachfolgend anhand der beigefügten Figuren detailliert beschrieben.

Es zeigen:
- Fig. 1: eine schematische Darstellung eines medizinischen Geräts mit einer Vorrichtung zur Benutzerassistenz basierend auf einer Ausführungsform der Erfindung; und
- Fig. 2: ein Flussdiagramm, welches die Durchführung einer Ausführungsform des erfindungsgemäßen Verfahrens verdeutlicht.

Nachfolgend wird eine Variante des erfindungsgemäßen Verfahrens beispielhaft anhand der Bewegungsplanung eines medizinischen Geräts in der Form eines C-Bogens erläutert.

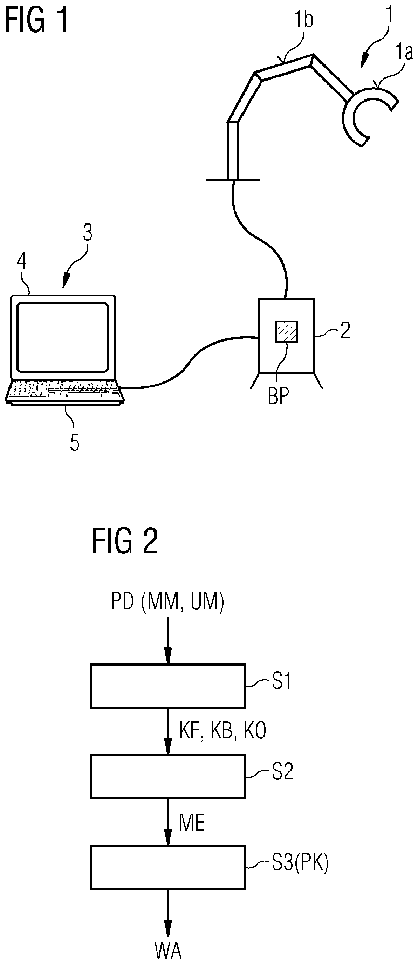

Fig. 1 zeigt den C-Bogen 1 mit einer vorderen C-förmigen Röntgeneinrichtung 1a, die über eine Gelenkanordnung 1b in eine Vielzahl von Positionen in Bezug auf einen nicht dargestellten Patienten verfahren werden kann, um bestimmte Bereiche des Patientenkörpers zu röntgen. Damit der C-Bogen Bewegungen ausführt, die nicht zu einer Kollision mit sich selbst oder Objekten in der Umgebung führen, wird ein Bewegungsplaner BP in der Form eines Programms verwendet, das in einem Rechner 2 ausgeführt wird. Der Bewegungsplaner ist zur Verwendung für unterschiedliche Typen von C-Bögen und in unterschiedlichen räumlichen Umgebungen ausgelegt. Deshalb müssen für den Bewegungsplaner Parametrierungsdaten spezifiziert werden. Diese Parametrierungsdaten werden über eine Benutzerschnittstelle 3 eingegeben und in dem Bewegungsplaner BP hinterlegt. Die Benutzerschnittstelle umfasst hierzu ein visuelles Anzeigemittel in der Form eines Bildschirms 4 sowie eine Tastatur 5.

Um vor der tatsächlichen Ausführung des Bewegungsplaners zur Ansteuerung des C-Bogens 1 eventuelle Fehler in den Parametrierungsdaten zu ermitteln, wird das im Folgenden beschriebene Verfahren zur Benutzerassistenz verwendet, das durch Programmcode in dem Rechner 2 implementiert ist. Dabei ist zu beachten, dass das Verfahren nicht unbedingt auf einem Rechner ablaufen muss, der zur Steuerung der tatsächlichen Maschine dient. Vielmehr kann das Verfahren zur Benutzerassistenz auch auf einem Rechner mit dort gespeichertem Bewegungsplaner in Kombination mit einer Benutzerschnittstelle unabhängig von der zu steuernden Maschine ausgeführt werden. Nach Parametrierung des Bewegungsplaners mit Hilfe des Verfahrens zur Benutzerassistenz muss der Planer dann auf den entsprechenden Rechner zur Steuerung der Maschine übertragen werden.

Gemäß dem Verfahren der Fig. 2 werden Parametrierungsdaten PD verarbeitet, die über die Benutzerschnittstelle 3 durch einen Benutzer eingegeben wurden. Solche Parametrierungsdaten sind an sich bekannt und umfassen ein Maschinenmodell MM und ein Umgebungsmodell UM. Das Maschinenmodell MM beschreibt unter anderem die geometrischen Abmessungen der entsprechenden Maschine, die in dem Beispiel der Fig. 1 einen C-Bogen darstellt. Das Umgebungsmodell UM beschreibt die räumlichen Gegebenheiten im Umfeld der Maschine, insbesondere die Positionen von Wänden und Decken und von anderen Objekten im Raum, in dem sich die Maschine befindet. Anstatt die Parametrierungsdaten direkt über die Benutzerschnittstelle einzugeben, kann der Benutzer diese Daten auch auf andere Weise spezifizieren, z.B. indem er über die Benutzerschnittstelle eine Datei festlegt, aus der die Parametrierungsdaten ausgelesen werden sollen.

Nach Einlesen der Parametrierungsdaten PD wird im Schritt S1 der Fig. 2 der kollisionsfreie Bewegungsraum KF und der kollisionsbehaftete Bewegungsraum KB der Maschine im Konfigurationsraum KO ermittelt, wobei der Konfigurationsraum einen Raum von Positionsvektoren darstellt, welche als Einträge die möglichen Positionen von jeweiligen Achsen der Maschine enthalten. Für jeden der Einträge ist dabei ein Wertbereich gegeben, der die möglichen Achswerte wiedergibt. Für Gelenkachsen sind diese Werte Winkelangaben und für Teleskopachsen Längenangaben.

Der Konfigurationsraum KO ist durch das Maschinenmodell MM gegeben. Der kollisionsfreie Bewegungsraum KF beschreibt im Konfigurationsraum KO Gebiete, in denen es nicht zu Kollisionen zwischen Maschinenkomponenten bzw. zwischen der Maschine und anderen Objekten kommen kann. Demgegenüber beschreibt der kollisionsbehaftete Bewegungsraum KB im Konfigurationsraum KO Bereiche, bei denen es zu Kollisionen zwischen Maschinenkomponenten bzw. zwischen der Maschine und anderen Objekten kommt.

Nach Bestimmung der Bewegungsräume KF und KB werden in Schritt S2 der Fig. 2 eine oder mehrere Merkmale ME in Bezug auf den kollisionsfreien bzw. kollisionsbehafteten Bewegungsraum ermittelt. Für eines oder mehrere dieser Merkmale wird in Schritt S3 ein vorgegebenes Plausibilitätskriterium PK überprüft, wobei im Falle, dass das Plausibilitätskriterium nicht erfüllt ist, über die Benutzerschnittstelle eine Warnmeldung WA ausgegeben wird.

Im Folgenden werden Beispiele von Merkmale ME und darauf basierenden Warnmeldungen WA gegeben. In einer Variante kann als Merkmal ME das relative Volumen des kollisionsfreien Konfigurationsraums, d.h. das Verhältnis des kollisionsfreien Bewegungsraums zum gesamten Konfigurationsraum, ermittelt werden. In diesem Fall stellt das Plausibilitätskriterium PK eine Schwelle für dieses Volumen dar, bei deren Unterschreiten das Kriterium nicht erfüllt ist. Mit anderen Worten wird über das Plausibilitätskriterium darauf hingewiesen, dass der kollisionsfreie Bewegungsraum sehr klein ist und somit eine große Gefahr für Kollisionen besteht. Bei Nichterfüllung des Plausibilitätskriteriums wird im beschriebenen Szenario eine Warnmeldung WA ausgegeben, welche dem Benutzer mitteilt, dass möglicherweise ein Fehler im Maschinenmodell besteht und einzelne Komponenten der Maschine zu grob (d.h. nicht mit ausreichender Feingranularität) modelliert oder falsch platziert sein könnten.

Sollte es mit dem Planer BP möglich sein, verschiedene Planungsalgorithmen zu verwenden, kann ggf. im Rahmen der Ausgabe der Warnmeldung WA auch ein Vorschlag für einen geeigneten Planer in Abhängigkeit vom relativen Volumen des kollisionsfreien Konfigurationsraums gegeben werden. Dabei werden über den Warnhinweis bei kleineren Volumina Planer mit systematischen Suchen vorgeschlagen, wohingegen bei größeren Volumina sampling-basierte Planer empfohlen werden. Die genannten Arten von Planern sind dem Fachmann hinlänglich bekannt.

In einer weiteren Ausführungsform wird als Merkmal ME die Anzahl der separaten zusammenhängenden kollisionsfreien Gebiete im Konfigurationsraum ermittelt. In einem zusammenhängenden Gebiet kann dabei jedes Paar von zwei Punkten über eine Bewegungstrajektorie erreicht werden, ohne dass das Gebiet verlassen wird. Das Plausibilitätskriterium PK ist in diesem Fall derart ausgestaltet, dass es nur bei einem einzelnen separaten zusammenhängenden kollisionsfreien Gebiet erfüllt ist. Gibt es mehrere separate zusammenhängende kollisionsfreien Gebiete, deutet dies auf einen Fehler im Umgebungsmodell UM hin. Demzufolge wird in diesem Fall ein Warnmeldung WA ausgegeben, welche darauf hinweist, dass möglicherweise Objekte, wie z.B. aus Sicherheitsgründen eingefügte künstliche Hindernisse, zu groß oder an einer falschen Stelle modelliert sind.

Sollte die soeben beschriebene Variante mit einem Bewegungsplaner kombiniert werden, in dem verschiedene Planungsalgorithmen verwendbar sind, wird in einer bevorzugten Ausführungsform über die Warnmeldung bei einer höheren Anzahl von separaten zusammenhängenden Gebieten ein Baum-basierter Planungsalgorithmus empfohlen, wohingegen bei weniger zusammenhängenden Gebieten Roadmap-basierte Planungsalgorithmen vorgeschlagen werden. Die genannten Arten von Planern sind dem Fachmann hinlänglich bekannt.

In einer weiteren Variante des erfindungsgemäßen Verfahrens werden der kollisionsbehaftete und der kollisionsfreie Bewegungsraum über eine Abtastung im Konfigurationsraum ermittelt. Dabei wird in geeigneter Weise (z.B. zufällig) eine Vielzahl von Positionsvektoren im Konfigurationsraum abgetastet, wobei für diese Vektoren ermittelt wird, ob bzw. welche Maschinenkomponenten der Maschine im kollisionsbehafteten Konfigurationsraum liegen. Hieraus wird die relative Häufigkeit von jeweiligen Maschinenkomponenten im kollisionsbehafteten Konfigurationsraum dadurch ermittelt, dass die Anzahl des Auftretens von Maschinenkomponenten im kollisionsbehafteten Konfigurationsraum für abgetastete Positionsvektoren durch die Gesamtanzahl der abgetasteten Positionsvektoren geteilt wird.

Das Plausibilitätskriterium PK ist in der soeben beschriebenen Ausführungsform derart ausgestaltet, dass eine Warnmeldung WA dann ausgegeben wird, wenn die relative Häufigkeit zumindest einer Maschinenkomponente eine vorgegebene Schwelle überschreitet. In diesem Fall wird in der Warnmeldung auch angegeben, welche Maschinenkomponenten die Schwelle überschritten haben. Ferner erhält der Benutzer den Hinweis, dass diese Maschinenkomponenten im Maschinenmodell zu groß oder zu grob modelliert sein könnten.

Die im Rahmen des Verfahrens der Fig. 2 ermittelten Merkmale ME können ggf. auch zur Analyse von an den Bewegungsplaner BP gerichteten Planungsanfragen genutzt werden. In diesem Fall kann über die Benutzerschnittstelle 3 auch eine Planungsanfrage in der Form einer Start- und Ziel-Konfiguration im Konfigurationsraum der Maschine eingegeben bzw. spezifiziert werden. Über das Merkmal der Lage und des Volumens von separaten zusammenhängenden kollisionsfreien Gebieten kann dann ermittelt werden, ob die Start- und Ziel-Konfiguration in unterschiedlichen kollisionsfreien Gebieten liegen oder ob Start- und/oder Zielposition außerhalb eines kollisionsfreien Gebiets liegen. Ist dies der Fall, gibt es keine kollisionsfreie Bewegungstrajektorie für die Maschine. In diesem Fall wird über die Benutzerschnittstelle eine Fehlermeldung ausgegeben, welche anzeigt, dass die Planungsanfrage nicht lösbar ist.

Sollte der Bewegungsplaner BP so ausgestaltet sein, dass er zur Bestimmung einer geeigneten Bewegungstrajektorie zwischen Start- und Ziel-Konfiguration eine Vielzahl von Trajektorien auf Kollisionsfreiheit testet, kann in einer weiteren Variante bei der Verarbeitung der Planungsanfrage auch ermittelt werden, wie häufig jeweilige Maschinenkomponenten für die getesteten Bewegungstrajektorien im kollisionsbehafteten Bewegungsraum liegen. Mit anderen Worten wird für eine jeweilige Maschinenkomponente der Quotient aus der Anzahl des Auftretens der jeweiligen Maschinenkomponente im kollisionsbehafteten Bewegungsraum für die getesteten Bewegungstrajektorien und der Gesamtanzahl der Trajektorien gebildet. Sollte diese Häufigkeit einen vorbestimmten Grenzwert für eine oder mehrere Maschinenkomponenten überschreiten, wird über die Benutzerschnittstelle für jede dieser Maschinenkomponenten die Information ausgegeben, dass diese Maschinenkomponente möglicherweise zu grob oder zu groß modelliert ist.

Die im Vorangegangenen beschriebenen Ausführungsformen der Erfindung weisen eine Reihe von Vorteilen auf. Insbesondere werden dem Benutzer bei der Inbetriebnahme eines Bewegungsplaners automatisiert Hinweise zu möglichen Fehlern in der Parametrierung des Bewegungsplaners gegeben, ohne dass hierzu die Hilfe von Experten benötigt wird. Dies beschleunigt die Inbetriebnahme des Planers und reduziert die Kosten für das Hinzuziehen von Planungsexperten. Darüber hinaus kann das erfindungsgemäße Verfahren den Benutzer ggf. auch bei Planungsanfragen unterstützen und ihn auf nicht-ausführbare Planungsanfragen bzw. auf mögliche Fehler im Bewegungsmodell oder Umgebungsmodell hinweisen.

## Patentansprüche

1. Verfahren zur rechnergestützten Benutzerassistenz bei der Inbetriebnahme eines Bewegungsplaners (BP) für eine Maschine (1), bei dem:
- eine Benutzerschnittstelle (3) bereitgestellt wird, über welche ein Benutzer Parametrierungsdaten (PD) für den Bewegungsplaner (BP) spezifizieren kann, wobei die Parametrierungsdaten (PD) ein Maschinenmodell (MM) und ein Umgebungsmodell (UM) umfassen, wobei das Maschinenmodell (MM) die geometrischen Abmessungen der Maschine (1) enthält und das Umgebungsmodell (UM) die geometrischen Abmessungen der Umgebung enthält, in der die Maschine (1) betrieben werden soll;
- basierend auf über die Benutzerschnittstelle (3) spezifizierten Parametrierungsdaten (PD) der kollisionsfreie und der kollisionsbehaftete Bewegungsraum (KF, KB) der Maschine (1) im Konfigurationsraum (KO) ermittelt wird, wobei der Konfigurationsraum (KO) einen Raum von Positionsvektoren darstellt, welche jeweils eine räumliche Lage der Maschine (1) repräsentieren;
- ein oder mehrere Merkmale (ME) in Bezug auf den kollisionsfreien und/oder kollisionsbehafteten Bewegungsraum (KF, KR) ermittelt werden;
- für ein jeweiliges Merkmal (ME) zumindest eines Teils der Merkmale (ME) ein vorgegebenes Plausibilitätskriterium (PK) überprüft wird,
**dadurch gekennzeichnet, dass**
im Falle, dass das Plausibilitätskriterium (PK) nicht erfüllt ist, über die Benutzerschnittstelle (3) eine Ausgabe in der Form einer Warnmeldung (WA) erzeugt wird, welche den Hinweis umfasst, dass das Maschinenmodell (MM) und/oder das Umgebungsmodell (UM) möglicherweise fehlerbehaftet sind.

2. Verfahren nach Anspruch 1, wobei der Bewegungsplaner (BP) mit unterschiedlichen Planungsalgorithmen betreibbar ist, wobei die Warnmeldung (WA) eine Empfehlung für zumindest einen dieser Planungsalgorithmen umfasst, der am besten für die spezifizierten Parametrierungsdaten (PD) geeignet ist.

3. Verfahren nach Anspruch 1 oder 2, wobei als ein Merkmal (ME) das Verhältnis des Volumens des kollisionsfreien Bewegungsraums (KF) zum Volumen des Konfigurationsraums (KO) oder des kollisionsbehafteten Bewegungsraums (KB) ermittelt wird, wobei das Plausibilitätskriterium dann erfüllt ist, wenn das Verhältnis eine vorgegebene Schwelle überschreitet.

4. Verfahren nach einem der vorhergehenden Ansprüche, wobei als ein Merkmal (ME) die Anzahl an separaten zusammenhängenden kollisionsfreien Gebieten im Konfigurationsraum (KO) ermittelt wird, wobei das Plausibilitätskriterium (PK) dann erfüllt ist, wenn es nur ein separates zusammenhängendes kollisionsfreies Gebiet gibt.

5. Verfahren nach einem der vorhergehenden Ansprüche, wobei im Rahmen der Ermittlung des kollisionsfreien und kollisionsbehafteten Bewegungsraums (KF, KB) der Konfigurationsraum (KO) abgetastet wird und für jeden Abtastwert bestimmt wird, ob der Abtastwert zu Kollisionen führt oder nicht.

6. Verfahren nach Anspruch 5, wobei im Rahmen der Abtastung des Konfigurationsraums (KO) als ein Merkmal die Häufigkeit des Auftretens jeweiliger Maschinenkomponenten im kollisionsbehafteten Konfigurationsraum (KB) in Bezug auf die Gesamtanzahl der Abtastwerte bestimmt wird und das Plausibilitätskriterium dann erfüllt ist, wenn die Häufigkeit des Auftretens zumindest einer Maschinenkomponente einen vorgegebenen Schwellwert überschreitet, wobei die Warnmeldung (WA) für jede Maschinenkomponenten, deren Häufigkeit den vorgegebenen Schwellwert überschreitet, den Hinweis enthält, dass diese Maschinenkomponente möglicherweise unzutreffend modelliert ist.

7. Verfahren nach einem der vorhergehenden Ansprüche, wobei über die Benutzerschnittstelle (3) ferner eine Planungsanfrage mit Start- und Ziel-Konfiguration der Maschine (1) spezifizierbar ist, wobei basierend auf einem ermittelten Merkmal, welches die Lage und das Volumen von separaten zusammenhängenden kollisionsfreien Gebieten im Konfigurationsraum (KO) spezifiziert, bestimmt wird, ob eine spezifizierte Planungsanfrage lösbar ist, wobei im Falle, dass die Planungsanfrage nicht lösbar ist, eine Fehlermeldung über die Benutzerschnittstelle (3) ausgegeben wird.

8. Verfahren nach einem der vorhergehenden Ansprüche, wobei über die Benutzerschnittstelle (3) ferner eine Planungsanfrage mit Start- und Ziel-Konfiguration der Maschine (1) spezifizierbar ist und im Rahmen der Verarbeitung einer spezifizierten Planungsanfrage eine Vielzahl von Bewegungstrajektorien zwischen Start- und Ziel-Konfiguration berechnet wird, bis eine Bewegungstrajektorie im kollisionsfreien Bewegungsraum (KF) gefunden ist oder ein Abbruchkriterium erfüllt ist, wobei für die berechneten Bewegungstrajektorien die Häufigkeit des Auftretens jeweiliger Maschinenkomponenten im kollisionsbehafteten Bewegungsraum (KB) in Bezug auf die Gesamtanzahl der berechneten Bewegungstrajektorien ermittelt wird und für Maschinenkomponenten, deren Häufigkeit einen vorgegebenen Grenzwert überschreitet, ein Warnhinweis über die Benutzerschnittstelle (3) ausgegeben wird.

9. Verfahren nach einem der vorhergehenden Ansprüche, wobei die Maschine (1) einen Industrieroboter oder ein medizinisches Gerät, insbesondere ein bildgebendes Gerät, oder eine Werkzugmaschine umfasst.

10. Vorrichtung zur rechnergestützten Benutzerassistenz bei der Inbetriebnahme eines Bewegungsplaners (BP) für eine Maschine (1), umfassend:
eine Benutzerschnittstelle (3), über welche ein Benutzer Parametrierungsdaten (PD) für den Bewegungsplaner (BP) spezifizieren kann, wobei die Parametrierungsdaten (PD) ein Maschinenmodell (MM) und ein Umgebungsmodell (UM) umfassen, wobei das Maschinenmodell (MM) die geometrischen Abmessungen der Maschine (1) enthält und das Umgebungsmodell (UM) die geometrischen Abmessungen der Umgebung enthält, in der die Maschine (1) betrieben werden soll;
ein Rechnermittel (2), welches dazu eingerichtet ist, um
- basierend auf über die Benutzerschnittstelle (3) spezifizierten Parametrierungsdaten (PD) den kollisionsfreien und den kollisionsbehafteten Bewegungsraum (KF, KB) der Maschine (1) im Konfigurationsraum (KO) zu ermitteln, wobei der Konfigurationsraum (KO) einen Raum von Positionsvektoren darstellt, welche jeweils eine räumliche Lage der Maschine (1) repräsentieren;
- ein oder mehrere Merkmale (ME) in Bezug auf den kollisionsfreien und/oder kollisionsbehafteten Bewegungsraum (KF, KR) zu ermitteln;
- für ein jeweiliges Merkmal (ME) zumindest eines Teils der Merkmale (ME) ein vorgegebenes Plausibilitätskriterium (PK) zu überprüfen,
**dadurch gekennzeichnet, dass**
im Falle, dass das Plausibilitätskriterium (PK) nicht erfüllt ist, das Rechnermittel (2) eine Ausgabe über die Benutzerschnittstelle (3) in der Form einer Warnmeldung (WA) auslöst, welche den Hinweis umfasst, dass das Maschinenmodell (MM) und/oder das Umgebungsmodell (UM) möglicherweise fehlerbehaftet sind.

11. Vorrichtung nach Anspruch 10, wobei die Vorrichtung zur Durchführung eines Verfahrens nach einem der Ansprüche 2 bis 9 eingerichtet ist.

12. Maschine, welche über einen Bewegungsplaner (BP) steuerbar ist, wobei die Maschine (1) eine Vorrichtung nach Anspruch 10 oder 11 zur rechnergestützten Benutzerassistenz bei der Inbetriebnahme des Bewegungsplaners (BP) umfasst.

13. Computerprogrammprodukt mit einem auf einem maschinenlesbaren Träger gespeicherten Programmcode zur Durchführung eines Verfahrens nach einem der Ansprüche 1 bis 9, wenn der Programmcode auf einem Computer ausgeführt wird.

14. Computerprogramm mit einem Programmcode zur Durchführung eines Verfahrens nach einem der Ansprüche 1 bis 9, wenn der Programmcode auf einem Computer ausgeführt wird.

## Claims

1. Method for computer-aided user assistance during the activation of a movement planner (BP) for a machine (1), in which:
- a user interface (3) is provided and can be used by a user to specify parameterization data (PD) for the movement planner (BP), wherein the parameterization data (PD) comprise a machine model (MM) and an environment model (UM), wherein the machine model (MM) contains the geometric dimensions of the machine (1) and the environment model (UM) contains the geometric dimensions of the environment in which the machine (1) is intended to be operated;
- the collision-free movement space (KF) and the collision-prone movement space (KB) of the machine (1) in the configuration space (KO) are determined on the basis of parameterization data (PD) specified via the user interface (3), wherein the configuration space (KO) is a space of position vectors each representing a spatial position of the machine (1);
- one or more features (ME) with respect to the collision-free and/or collision-prone movement space (KF, KB) are determined;
- a predefined plausibility criterion (PK) is checked for a respective feature (ME) of at least some of the features (ME),
**characterized in that**,
if the plausibility criterion (PK) has not been satisfied, an output in the form of a warning message (WA) is produced via the user interface (3), which warning message comprises the notification that the machine model (MM) and/or the environment model (UM) possibly has/have errors.

2. Method according to Claim 1, wherein the movement planner (BP) can be operated with different planning algorithms, wherein the warning message (WA) comprises a recommendation for at least one of these planning algorithms which is best suited to the specified parameterization data (PD).

3. Method according to Claim 1 or 2, wherein the ratio of the volume of the collision-free movement space (KF) to the volume of the configuration space (KO) or of the collision-prone movement space (KB) is determined as a feature (ME), wherein the plausibility criterion has been satisfied when the ratio exceeds a predefined threshold.

4. Method according to one of the preceding claims, wherein the number of separate contiguous collision-free areas in the configuration space (KO) is determined as a feature (ME), wherein the plausibility criterion (PK) has been satisfied when there is only one separate contiguous collision-free area.

5. Method according to one of the preceding claims, wherein, when determining the collision-free movement space (KF) and the collision-prone movement space (KB), the configuration space (KO) is sampled and, for each sample value, it is determined whether or not the sample value results in collisions.

6. Method according to Claim 5, wherein, when sampling the configuration space (KO), the frequency of the occurrence of respective machine components in the collision-prone movement space (KB) with respect to the total number of sample values is determined as a feature, and the plausibility criterion has been satisfied when the frequency of the occurrence of at least one machine component exceeds a predefined threshold value, wherein the warning message (WA) contains, for each machine component whose frequency exceeds the predefined threshold value, the notification that this machine component has possibly been modeled incorrectly.

7. Method according to one of the preceding claims, wherein a planning request with a start configuration and a target configuration of the machine (1) can also be specified via the user interface (3), wherein it is determined, on the basis of a determined feature specifying the position and the volume of separate contiguous collision-free areas in the configuration space (KO), whether a specified planning request can be tackled, wherein, if the planning request cannot be tackled, an error message is output via the user interface (3).

8. Method according to one of the preceding claims, wherein a planning request with a start configuration and a target configuration of the machine (1) can also be specified via the user interface (3) and a multiplicity of movement trajectories between the start configuration and the target configuration are calculated when processing a specified planning request until a movement trajectory in the collision-free movement space (KF) has been found or an abort criterion has been satisfied, wherein the frequency of the occurrence of respective machine components in the collision-prone movement space (KB) with respect to the total number of calculated movement trajectories is determined for the calculated movement trajectories and a warning notification is output via the user interface (3) for machine components whose frequency exceeds a predefined limit value.

9. Method according to one of the preceding claims, wherein the machine (1) comprises an industrial robot or a medical device, in particular an imaging device, or a machine tool.

10. Apparatus for computer-aided user assistance during the activation of a movement planner (BP) for a machine (1), comprising:
a user interface (3) which can be used by a user to specify parameterization data (PD) for the movement planner (BP), wherein the parameterization data (PD) comprise a machine model (MM) and an environment model (UM), wherein the machine model (MM) contains the geometric dimensions of the machine (1) and the environment model (UM) contains the geometric dimensions of the environment in which the machine (1) is intended to be operated;
a computer means (2) which is set up
- to determine the collision-free movement space (KF) and the collision-prone movement space (KB) of the machine (1) in the configuration space (KO) on the basis of parameterization data (PD) specified via the user interface (3), wherein the configuration space (KO) is a space of position vectors each representing a spatial position of the machine (1);
- to determine one or more features (ME) with respect to the collision-free and/or collision-prone movement space (KF, KB) ;
- to check a predefined plausibility criterion (PK) for a respective feature (ME) of at least some of the features (ME),
**characterized in that**,
if the plausibility criterion (PK) has not been satisfied, the computer means (2) triggers an output via the user interface (3) in the form of a warning message (WA), which warning message comprises the notification that the machine model (MM) and/or the environment model (UM) possibly has/have errors.

11. Apparatus according to Claim 11, wherein the apparatus is set up to carry out a method according to one of Claims 2 to 9.

12. Machine which can be controlled via a movement planner (BP), wherein the machine (1) comprises an apparatus according to Claim 10 or 11 for computer-aided user assistance during the activation of the movement planner (BP).

13. Computer program product having a program code which is stored on a machine-readable carrier and is intended to carry out a method according to one of Claims 1 to 9 when the program code is executed on a computer.

14. Computer program having a program code for carrying out a method according to one of Claims 1 to 9 when the program code is executed on a computer.

## Revendications

1. Procédé d'aide à l'utilisateur assistée par ordinateur lors de la mise en service d'un planificateur de déplacement (BP) pour une machine (1), dans lequel :
une interface utilisateur (3) est fournie, via laquelle un utilisateur peut spécifier des données de paramétrage (PD) pour le planificateur de déplacement (BP), les données de paramétrage (PD) comprenant un modèle de machine (MM) et un modèle d'environnement (UM), le modèle de machine (MM) contenant les dimensions géométriques de la machine (1) et le modèle d'environnement (UM) contenant les dimensions géométriques de l'environnement dans lequel la machine (1) doit être exploitée ;
sont déterminés, sur la base de données de paramétrage (PD) spécifiées via l'interface utilisateur (3), l'espace de déplacement de la machine (1) sans collision et celui avec collisions (KF, KB) dans l'espace de configuration (KO), l'espace de configuration (KO) représentant un espace de vecteurs de position qui représentent respectivement une position spatiale de la machine (1) ;
une ou plusieurs caractéristiques (ME) sont déterminées en rapport avec l'espace de déplacement sans collision et/ou celui avec collisions (KF, KR) ;
est vérifié, pour une caractéristique (ME) respective d'au moins une partie des caractéristiques (ME), un critère de plausibilité donné (PK),
**caractérisé en ce que**
est générée via l'interface utilisateur (3), si le critère de plausibilité (PK) n'est pas rempli, une émission sous la forme d'un message d'avertissement (WA), laquelle inclut l'information que le modèle de machine (MM) et/ou le modèle d'environnement (UM) sont peut-être erronés.

2. Procédé selon la revendication 1, le planificateur de déplacement (BP) pouvant être exploité avec différents algorithmes de planification, le message d'avertissement (WA) contenant une recommandation pour au moins un de ces algorithmes de planification qui convient le mieux pour les données de paramétrage spécifiées (PD).

3. Procédé selon la revendication 1 ou 2, en tant que caractéristique (ME) étant déterminé le rapport entre le volume de l'espace de déplacement sans collision (KF) et le volume de l'espace de configurations (KO) ou de l'espace de déplacement avec collisions (KB), le critère de plausibilité étant rempli lorsque le rapport dépasse un seuil donné.

4. Procédé selon l'une des revendications précédentes, en tant que caractéristique (ME) étant déterminé le nombre de zones séparées connexes sans collision dans l'espace de configuration (KO), le critère de plausibilité (PK) étant rempli s'il n'y a qu'une zone séparée connexe sans collision.

5. Procédé selon l'une des revendications précédentes, l'espace de configuration (KO) étant balayé dans le cadre de la détermination de l'espace de déplacement sans collision et de celui avec collisions (KF, KB) et il est déterminé, pour chaque valeur de balayage, si la valeur de balayage entraîne des collisions ou non.

6. Procédé selon la revendication 5, dans le cadre du balayage de l'espace de configuration (KO) étant déterminée, en tant que caractéristique, la fréquence de la survenance de composants machine respectifs dans l'espace de configuration avec collisions (KB) rapportée au nombre total de valeurs de balayage et le critère de plausibilité étant rempli si la fréquence de la survenance d'au moins un composant machine dépasse une valeur seuil donnée, le message d'avertissement (WA) contenant, pour chaque composant machine dont la fréquence dépasse la valeur seuil donnée l'information que ce composant machine est peut-être modélisé incorrectement.

7. Procédé selon l'une des revendications précédentes, via l'interface utilisateur (3) pouvant en outre être spécifiée une requête de planification avec configuration de départ et configuration cible de la machine (1), sur la base d'une caractéristique déterminée qui spécifie la position et le volume de zones séparées connexes sans collision dans l'espace de configuration (KO) étant déterminé si une requête de planification spécifiée peut être résolue, un message d'erreur étant émis via l'interface utilisateur (3) dans le cas où la requête de planification ne peut pas être résolue.

8. Procédé selon l'une des revendications précédentes, via l'interface utilisateur (3) pouvant en outre être spécifiée une requête de planification avec configuration de départ et configuration cible de la machine (1) et une pluralité de trajectoires de déplacement entre configuration de départ et configuration cible étant calculée dans le cadre du traitement d'une requête de planification spécifiée jusqu'à ce qu'une trajectoire de déplacement soit trouvée dans l'espace de déplacement sans collision (KF) ou jusqu'à ce qu'un critère d'interruption soit rempli, pour les trajectoires de déplacement calculées étant déterminée la fréquence de la survenance de composants machine respectifs dans l'espace de déplacement avec collisions (KB) rapportée au nombre total de trajectoires de déplacement calculées et un message d'avertissement étant émis via l'interface utilisateur (3) pour des composants machine dont la fréquence dépasse une valeur limite donnée.

9. Procédé selon l'une des revendications précédentes, la machine (1) comprenant un robot industriel ou un appareil médical, et plus particulièrement un appareil d'imagerie, ou une machine-outil.

10. Dispositif d'aide à l'utilisateur assistée par ordinateur lors de la mise en service d'un planificateur de déplacement (BP) pour une machine (1), comprenant :
une interface utilisateur (3) via laquelle un utilisateur peut spécifier des données de paramétrage (PD) pour le planificateur de déplacement (BP), les données de paramétrage (PD) comprenant un modèle de machine (MM) et un modèle d'environnement (UM), le modèle de machine (MM) contenant les dimensions géométriques de la machine (1) et le modèle d'environnement (UM) contenant les dimensions géométriques de l'environnement dans lequel la machine (1) doit être exploitée ;
un moyen de calcul (2) qui est configuré pour : déterminer, sur la base de données de paramétrage (PD) spécifiées via l'interface utilisateur (3), l'espace de déplacement de la machine (1) sans collision et celui avec collisions (KF, KB) dans l'espace de configuration (KO), l'espace de configuration (KO) représentant un espace de vecteurs de position qui représentent respectivement une position spatiale de la machine (1) ;
déterminer une ou plusieurs caractéristiques (ME) en rapport avec l'espace de déplacement sans collision et/ou celui avec collisions (KF, KR) ;
vérifier, pour une caractéristique (ME) respective d'au moins une partie des caractéristiques (ME), un critère de plausibilité donné (PK),
**caractérisé en ce que**
le moyen de calcul (2) déclenche, via l'interface utilisateur (3), si le critère de plausibilité (PK) n'est pas rempli, une émission sous la forme d'un message d'avertissement (WA) qui inclut l'information que le modèle de machine (MM) et/ou le modèle d'environnement (UM) sont peut-être erronés.

11. Dispositif selon la revendication 10, le dispositif étant configuré pour exécuter un procédé selon l'une des revendications 2 à 9.

12. Machine qui peut être commandée par l'intermédiaire d'un planificateur de déplacement (BP), la machine (1) comprenant un dispositif selon la revendication 10 ou 11 pour l'aide à l'utilisateur assistée par ordinateur lors de la mise en service du planificateur de déplacement (BP).

13. Produit de programme informatique avec un code de programme stocké sur un support lisible par machine pour exécuter un procédé selon l'une des revendications 1 à 9 lorsque le code de programme est exécuté sur un ordinateur.

14. Produit de programme informatique avec un code de programme pour exécuter un procédé selon l'une des revendications 1 à 9 lorsque le code de programme est exécuté sur un ordinateur.
